(19) Europäisches Patentamt
European Patent Office
Office européen des brevets

(11) Publication number : **0 532 076 B1**

# (12) EUROPEAN PATENT SPECIFICATION

(45) Date of publication of patent specification : **14.06.95 Bulletin 95/24**

(51) Int. Cl.[6] : **G03F 7/07,** G03C 1/74

(21) Application number : **92202587.9**

(22) Date of filing : **25.08.92**

## (54) Silver salt diffusion transfer type lithographic printing plate.

(30) Priority : **10.09.91 EP 91202309**

(43) Date of publication of application : **17.03.93 Bulletin 93/11**

(45) Publication of the grant of the patent : **14.06.95 Bulletin 95/24**

(84) Designated Contracting States : **BE DE FR GB NL**

(56) References cited :
**EP-A- 0 068 627**
**EP-A- 0 087 176**
**PATENT ABSTRACTS OF JAPAN vol. 12, no. 415 (P-781)(3262) 4 November 1988**

(73) Proprietor : **AGFA-GEVAERT naamloze vennootschap**
**Septestraat 27**
**B-2640 Mortsel (BE)**

(72) Inventor : **Berendsen, Jules Robert, c/o Agfa-Gevaert N.V.**
**DIE 3800, Septestraat 27**
**B-2640 Mortsel (BE)**
Inventor : **Vandenbruwaene, Rik, c/o Agfa-Gevaert N.V.**
**DIE 3800, Septestraat 27**
**B-2640 Mortsel (BE)**
Inventor : **Degrauwe, Dirk Michel, c/o Agfa-Gevaert N.V.**
**DIE 3800, Septestraat 27**
**B-2640 Mortsel (BE)**

EP 0 532 076 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

1. Field of the invention.

The present invention relates to a method for manufacturing a lithographic printing plate precursor and to a method for producing a lithographic printing plate therewith.

2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. For example the United Kingdom Patent Specification 1,241,661 discloses a method for the production of a planographic printing plate consisting of a sheet material comprising an outer hydrophilic colloid layer on the surface of which there is concentrated a silver image stemming from an underlying exposed silver halide emulsion layer by the silver complex diffusion transfer reversal process.

Numerous attempts have been made to improve the lithographic printing properties especially the printing endurance of such a lithographic printing plate. These attempts are illustrated by the following disclosures.

The US patents US-4,297,429, US-4,297,430 and US-4,355,290 disclose the use of respectively cyclic imides, oxazolidones and 2-mercaptobenzoic acid as silver halide solvents in the DTR-process for improving the lithographic printing properties. Japanese patent no 1,355,795 discloses an imaging element as lithographic printing plate precursor containing most of the matting agent used in the base layer comprised between the support and the photosensitive silver halide emulsion layer. In DE 39 06 676 it is disclosed to include an intermediate hydrophilic layer between the photosensitive layer and the layer containing physical development nuclei for increasing the printing endurance. For the same purpose US-4,772,535 discloses the use of a light insensitive silver halide layer between the support and the photosensitive silver halide layer. Still other disclosures relating to the improvement of the lithographic printing properties of DTR-monosheet printing plates are well known to the person skilled in the art.

EP-A-87176 discloses a lithographic printing plate precursor obtained by coating an anti-halation layer, emulsion layer and nuclei layer in that order on a support. The anti-halation layer is coated using a solution containing 6.4 % of gelatin. EP-A-68627 discloses a similar method for making a printing plate precursor.

Despite these numerous publications the need still exists for further improving the printing properties especially the printing endurance of DTR-monosheet printing plates.

3. Summary of the invention.

Accordingly it is an object of the present invention to provide a method for manufacturing a lithographic printing plate precursor for making a lithographic printing plate according to the silver salt diffusion transfer process whereby said printing plate has improved lithographic properties.

It is a further object of the present invention to provide a method for obtaining a lithographic printing plate having improved lithographic printing properties.

Still further objects of the present invention will become clear from the description hereinafter.

According to the present invention there is provided a method for producing a lithographic printing plate precursor comprising the steps of coating on one side of a support a photosensitive layer containing a silver halide emulsion, a surface layer containing physical development nuclei and optional hydrophilic layers in water

permeable relationship with said photosensitive and said hydrophilic surface layer characterized in that at least one of said layers on said support are coated from a coating solution containing a hydrophilic colloid in a concentration of at least 7% by weight.

According to the present invention there is provided a method for obtaining a lithographic printing plate according to the DTR-process using the lithographic printing plate precursor obtained by the above described method.

4. Detailed description of the invention.

It has surprisingly been found by the inventors that coating of at least one of the layers contained on the photosensitive side of the support of an imaging element to be used as a printing plate also called a lithographic printing plate precursor from a coating solution containing a hydrophilic colloid in a concentration of at least 7% by weight yields printing plates after imaging and development according to the DTR-process with improved printing endurance with respect to imaging elements of which all said layers were coated from coating solutions containing hydrophilic colloid in a concentration less than 7% by weight.

The upper limit of the concentration of the hydrophilic colloid in the coating liquid is not critical in the present invention. The actual concentration of the hydrophilic colloid used will depend on the coating technique, coating conditions, desired layer thickness etc. and can be easily determined with routine experiments by a person skilled in the art.

According to the coating method of the present invention the coating solutions containing hydrophilic colloid in a concentration of at least 7% by weight are preferably coated by means of curtain coating. This coating technique is especially suitable for use in accordance with the method of the present invention since in this way the final dry layer thickness of a layer coated from a coating solution containing at least 7% by weight can be kept the same as the dry layer thickness of a layer coated from a coating solution containing less hydrophilic colloid.

Furthermore with the curtain coating technique layers can be coated to a smaller wet layer thickness with respect to other coating techniques such as e.g. bead coating also called slide-hopper coating or cascade coating allowing a more rapid drying of the coated layers.

Details of the curtain coating technique are disclosed in e.g. US-P-3.632.374 (single layer coating) and US-P-3.508.947 (multi layer coating). Briefly the curtain coating technique is a technique by which a coating liquid is coated to a support by forming a free-falling curtain of said coating liquid and causing this curtain to impinge on the face of the moving support.

It is not clear what causes the increased printing endurance when a printing plate is made from an imaging element manufactured according to the invention. Possible causes are a faster drying of the layers, structuration of the layers, a different hardening level etc..

The imaging element used in accordance with the present invention essentially contains on one side of a support at least one silver halide emulsion layer and a surface-layer containing physical development nuclei. In a preferred embodiment of the present invention there is also provided a subbing layer or base layer between the support and the silver halide emulsion layer.

According to the present invention preferably the silver halide emulsion layer and base layer are curtain coated from a coating solution containing at least 7% by weight, preferably at least 7.5% by weight of hydrophilic colloid. The dry layer thickness of the silver halide emulsion is preferably between 0.5 μm and 2 μm while the dry layer thickness of said base layer is preferably between 1.5 μm and 4 μm the total dry layer thickness of both layers preferably being kept between 3 μm and 5 μm. Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide.

The photographic silver halide emulsions can be prepared from soluble silver salts and soluble halides according to different methods as described e.g. by P. Glafkides in "Chimie et Physique Photographique", Paul Montel , Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 μm , preferably from 0.25 to 0.45 μm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. A preferred green sensitizing dye in connection with the present invention is represented by the following chemical formula :

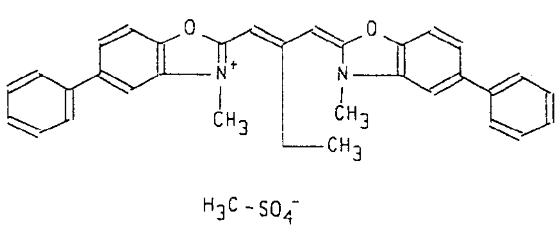

(1)

In case of exposure by a red light emitting source, e.g. a LED or a HeNe laser a red sensitizing dye is used. A preferred red sensitizing dye is :

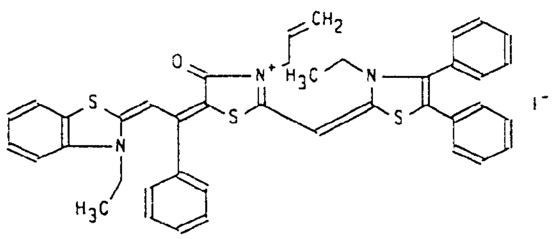

(2)

In case of exposure by an argon ion laser a blue sensizing dye is incorporated. A preferred blue sensitizing dye is represented by :

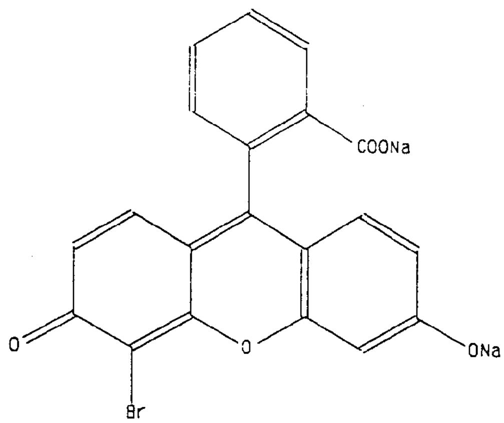

(3)

In case of exposure by a semiconductor laser special spectral sensitizing dyes suited for the near infra-red are required. Suitable infra-red sensitizing dyes are disclosed in i.a. US-P Nos 2,095,854, 2,095,856, 2,955,939, 3,482,978, 3,552,974, 3,573,921, 3,582,344, 3,623,881 and 3,695,888. A preferred infra-red sensitizing dye is :

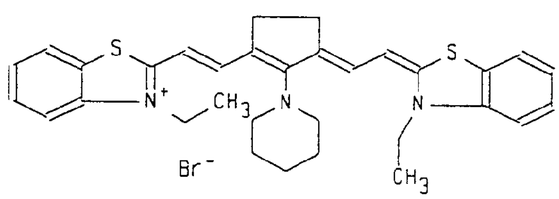

(4)

To enhance the sensitivity in the near infra-red region use can be made of so-called supersensitizers in combination with infra-red sensitizing dyes. Suitable supersensitizers are described in Research Disclosure Vol 289, May 1988, item 28952. A preferred supersensitizer is Compound IV of the Disclosure having following formula :

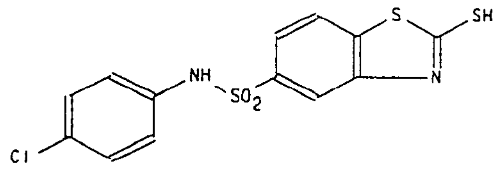

(5)

The spectral sensitizers can be added to the photographic emulsions in the form of an aqueous solution, a solution in an organic solvent or in the form of a dispersion.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787, DE-P 2,453,217, and GB-P 7,907,440.

In an especially preferred embodiment the emulsion layer contained in the imaging element contains a compound which comprises in its molecular structure a group capable of adsorbing to silver halide and a group capable of reducing silver halide. Compounds of this kind have been disclosed in EP-A-449340. In this way a combination of a stabilizing and a development activating function in one compound is achieved. A preferred compound belonging to this class is represented by the following formula :

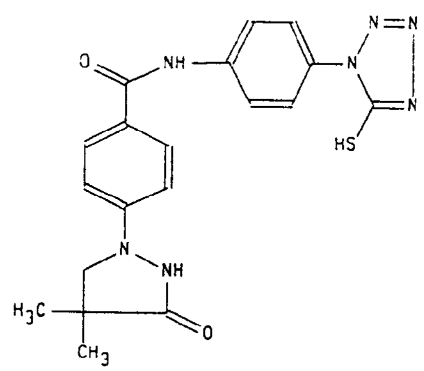

(6)

More details about the composition, preparation and coating of silver halide emulsions can be found in e.g. Product Licensing Index, Vol. 92, December 1971, publication 9232, p. 107-109.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

In addition to the above described emulsion layer and layer containing physical development nuclei other hydrophilic colloid layers in water permeable relationship with these layers may be present. For example additional silver halide emulsion layers may be present as disclosed in US-P-4,772,535, an intermediate hydrophilic colloid layer may be provided between the photosensitive silver halide emulsion layer and the surface layer containing physical development nuclei, etc.. It is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P 2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, anti static agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The hardening level of the layer package on the photosensitive side of the imaging element that will also form the printing side is an important factor in controlling the printing endurance of the lithographic printing plate obtained from such an imaging element. When the hardening level is too low the printing endurance will also be low while a too high hardening level will also yield low printing endurances since this will object the diffusion of the silver halide complexed by the silver solvent to the image receiving layer of physical development nuclei so that the strength of the silver image on the surface will be small.

The hardening level of a gelatine layer package on the photosensitive side of the imaging element can be determined using enzymatic hydrolysis of the gelatine. The procedure is as follows.

The photosensitive side of the imaging element is swollen in a buffer solution at pH=7. After 5min. an aqueous solution of 2% of protease 660L (commercially avalaible from Solvay) is applied to the swollen layers and the decrease of the thickness of the layers is measured with time. The procedure is carried out at 49°C. Since the enzymatic hydrolysis is directly related to the hardening level the hardening level can be expressed as the rate of hydrolysis under the above described conditions. The hardening level of the layer package on the photosensitive side of the imaging element according to the present invention is preferably between $0.4*10^{-2}\mu m/s$ and $1.5*10^{-2}\mu m/s$ expressed as the rate of decrease of the layer thickness under enzymatic hydrolysis.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol

alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The imaging element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

According to the method of the present invention the above described imaging element is information-wise exposed and subsequently developed according to the DTR-process. The DTR mono-sheet imaging element in connection with the present invention is exposed in an apparatus according to its particular application, e.g. a conventional process camera containing a conventional light source or a laser containing device. Examples of HeNe laser containing exposure units are the image-setters LINOTRONIC 300, marketed by LINOTYPE Co, and CG 9600, marketed by AGFA COMPUGRAPHIC, a division of AGFA CORPORATION. An image-setter provided with an Ar ion laser is LS 210, marketed by Dr-Ing RUDOLF HELL GmbH. Exposure units provided with a laserdiode are LINOTRONIC 200, marketed by LINOTYPE Co, and CG 9400, marketed by AGFA COMPUGRAPHIC, a division of AGFA CORPORATION.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Said developing agents may be contained in an alkaline processing liquid but are preferably contained in one or more layers of the imaging element. In the latter case the alkaline processing liquid merely serves as an alkaline activating liquid.

The pH of said activating liquid is preferably between 12 and 14 and may be established by an organic and/or inorganic alkali agent. Examples of suitable alkali agents are e.g. sodium hydroxide, carbonates, secundary and/or tertiary alkanolamines, amines etc. or mixtures thereof.

It is furthermore essential that the DTR-process is carried out in the presence of (a) silver halide solvent(s). Said silver halide solvent(s) can be present in one or more layers comprised in the imaging element but are preferably comprised in the alkaline processing liquid. Suitable silver halide solvents for use in accordance with the present invention are e.g. thiosulphate or thiocyanate. Further interesting silver halide complexing agents, are cyclic imides, preferably combined with alkanolamines, as described in US-P 4,297,430 and US-P 4,355,090 and 2-mercaptobenzoic acid derivatives as described in US-P 4,297,429, preferably combined with alkanolamines or with cyclic imides and alkanolamines.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

The alkaline processing liquid can contain one or more hydrophobizing agents to enhance the ink-receptive properties of the DTR silver image, e.g. those described in US-P 3,776,728, and US-P 4,563,410. Preferred compounds are 5-n-heptyl-2-mercapto-1,3,4,-oxadiazol and 3-mercapto-4-acetamido-5-n.heptyl-1,2,4-triazole.

Development acceleration can be accomplished with the aid of various compounds to the alkaline processing liquid and/or one or more layers of the imaging element, preferably polyalkylene derivatives having a molecular weight of at least 400 such as those described in e.g. US-P 3,038,805 - 4,038,075 - 4,292,400 - 4,975,354.

According to the method of the present invention an image-wise exposed monosheet-DTR imaging element is processed in an alkaline processing solution having a composition as described above. The development and diffusion transfer can be initiated in different ways e.g. by rubbing with a roller that has been wetted with the processing liquid, e.g. acts as meniscus coater, by wiping with an absorbent means e.g. with a plug of cotton or sponge, or by dipping the material to be treated in the liquid composition. Preferably, they proceed in an automatically operated apparatus such as RAPILINE SP 430, marketed by AGFA. The DTR-process is normally carried out at a temperature in the range of 10°C to 35°C. In order to minimize the quality loss due to bath exhaustion, regenerating liquids can be added in proportion to the consumption of processing liquids. Preferably the DTR material is subsequently guided through a neutralization solution. In order to reduce the pH of the wet swollen DTR element leaving the alkaline processing solution, the neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Finally the neutralization solution can contain wetting agents, preferably compouds containing perfluorinated alkyl groups.

The present invention will now be illustrated by the following example without however limiting it thereto. All parts are by weight unless otherwise specified.

EXAMPLE

Preparation of the silver halide emulsion coating solutions.

A silver chlorobromide emulsion composed of 98.2mole% of chloride and 1.8mole% of bromide was prepared by the double jet precipitation method. The average silver halide grain size was 0.4μm (diameter of a sphere with equivalent volume) and contained Rhodium ions as internal dopant. The emulsion was orthochromatically sensitized by means of compound 1 mentioned above and stabilized by a mixture of 1-phenyl-5-mercapto-tetrazole and a compound according to following formula:

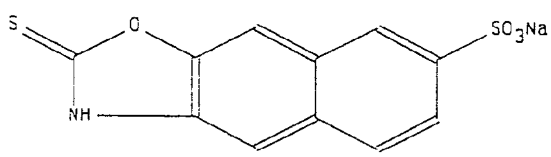

The amount of gelatin for the emulsion coating solution 1 and 2 was adjusted to respectively 5.3% and 8.1%.

Compositions of the coating solutions for the base layer.

Coating solution 1:

| | |
|---|---|
| gelatin | 5.5% |
| carbon black | 0.76% |
| silica particles (5μm) | 1.6% |

Coating solution 2:

| | |
|---|---|
| gelatin | 9% |
| carbon black | 0.76% |
| silica particles (5μm) | 1.6% |

Preparation of the imaging elements:

1) Comparitive imaging element:

Emulsion coating solution 1 and base layer coating solution 1 were simultaneously coated by means of the cascade coating technique to a transparent polyethyleneterephtalate support provided with a pack of two backing layers such that the base layer coating was coated directly to the side of the support opposite to the side containing said backing layers. The emulsion layer was coated such that the silver halide coverage expressed as $AgNO_3$ was 1.5g/m$^2$ and the gelatin content was 1.5g/m$^2$. The emulsion layer further contained 0.15g/m$^2$ of 1-phenyl-4,4′-dimethyl-3-pyrazolidone and 0.25g/m$^2$ of hydroquinone. The base layer was coated such that the amount of gelatin in the coated layer was 3g/m$^2$.

The layer nearest to the support of the backing layer pack contained 0.3 g/m$^2$ of gelatin and 0.5 g/m$^2$ of the antistatic agent co(tetraallyloxyethane / methacrylate / acrylic acid-K-salt) polymer. The second backing layer contained 4 g/m$^2$ of gelatin, 0.15 g/m$^2$ of a matting agent consisting of transparent spherical polymeric beads of 3 micron average diameter according to EP 0080225, 0.05 g/m$^2$ of hardening agent triacrylformal and 0.021 g/m$^2$ of wetting agent $F_{15}C_7$-$COONH_4$.

The thus obtained element was dried and subjected to a temperature of 40°C for 5 days and then the emulsion layer was overcoated using air-knife coating with a layer containing PdS as physical development nuclei, hydroquinone at 0.4g/m$^2$ and formaldehyde at 100mg/m$^2$.

2) Imaging element according to the invention.

An imaging element according to the invention was prepared similar to the procedure described for the comparitive imaging element with the difference however that emulsion coating solution 2 and base layer coating solution 2 described above were simultaneously coated to the support using curtain coating. The emulsion layer was coated such that the silver halide coverage expressed as $AgNO_3$ was 1.5g/m$^2$ and the gelatin content was 1.35g/m$^2$. The emulsion layer further contained 0.15g/m$^2$ of 1-phenyl-4,4′-dimethyl-3-pyrazolidone and 0.25g/m$^2$ of hydroquinone. The base layer was coated such that the amount of gelatin in the coated layer was 2.76g/m$^2$.

The following processing solutions were prepared :

<u>Transfer developper:</u>

| | |
|---|---|
| sodium hydroxide (g) | 30 |
| sodium sulphite anh.. (g) | 33 |
| potassium thiocyanate (g) | 20 |
| 3-mercapto-4-acetamido-5-n.heptyl-1,2,4-triazole (g) | 0.15 |
| water to make | 1 l |

<u>Neutralization solution</u>

| | |
|---|---|
| citric acid | 10 g |
| sodium citrate | 35 g |
| cysteine | 1 g |
| sodium sulphite anh. | 5 g |
| phenol | 50 mg |
| water to make | 1 l |

Dampening solution

| | |
|---|---|
| water | 880 ml |
| citric acid | 6g |
| boric acid | 8.4g |
| sodium sulphate anh. | 25g |
| ethyleneglycol | 100g |
| colloidal silica | 28g |

Both imaging elements were image-wise exposed and processed with the above described transfer developer, subsequently neutralized at 25 °C with the neutralization solution described above and dried.

Each of the 2 printing plates thus prepared were mounted on an offset printing machine ( AB Dick 9860 CD - trade name for offset printing machine manufactured by AB DICK Co). The ink used was K+E 125 commercially available from BASF. During the printing run the described dampening solution was used in each case.

The sensitometric properties of this material was characterized by the transmission ($D_{TR}$) and reflection ($D_{RE}$) density and the lithographic properties printing endurance was evaluated as the number of printed copies before disappearance of ink in the ink accepting areas begins to occur. The obtained results are as follows:

| Imaging element | $D_{RE}$ | $D_{TR}$ | Printing edurance |
|---|---|---|---|
| Comperative | 0.63 | 1.88 | 7000 |
| Invention | 0.58 | 1.86 | 12000 |

## Claims

1. A method for producing a lithographic printing plate precursor comprising the steps of coating on one side of a support a photosensitive layer containing a silver halide emulsion, a surface layer containing physical development nuclei and optional hydrophilic layers in water permeable relationship with said photosensitive and said hydrophilic surface layer characterized in that at least one of said layers on said support are coated from a coating solution containing a hydrophilic colloid in a concentration of at least 7% by weight.

2. A method according to claim 1 wherein said layers coated from a coating solution containing a hydrophilic colloid in a concentration of at least 7% by weight are coated using curtain coating.

3. A method according to claim 1 or 2 wherein said concentration of hydrophilic colloid is at least 7.5%.

4. A lithographic printing plate precursor obtainable by the method defined in any of claims 1 to 3.

5. A method for making a lithographic printing plate according to the DTR-process comprising the steps of:
   - information-wise exposing a lithographic printing plate precursor as defined in claim 4,
   - and developing said information-wise exposed lithographic printing plate precursor in the presence of developing agent(s) and silver halide solvent(s).

## Patentansprüche

1. Verfahren zur Herstellung eines Vorläufers einer lithografischen Druckplatte, das die folgenden Schritte umfaßt: Einseitiger Auftrag einer fotoempfindlichen Schicht, die eine Silberhalogenid-Emulsion enthält, einer Oberflächenschicht, die physikalische Entwicklungskeime enthält, und eventueller hydrophiler Schichten in wasserdurchlässiger Beziehung mit der fotoempfindlichen und der hydrophilen Oberflächenschicht auf einen Träger, dadurch gekennzeichnet, daß wenigstens eine dieser Schichten auf diesem Träger aus einer Gießlösung aufgetragen werden, die ein hydrophiles Kolloid in einer Konzentration von mindestens 7 Gewichts-% enthält.

**2.** Verfahren nach Anspruch 1, dadurch gekennzeichnet, daß die Schichten, aufgetragen aus einer Gießlösung, die ein hydrophiles Kolloid in einer Konzentration von mindestens 7 Gewichts-% enthält, nach der Vorhangbeschichtung aufgetragen werden.

**3.** Verfahren nach Anspruch 1 oder 2, dadurch gekennzeichnet, daß die Konzentration an hydrophilem Kolloid mindestens 7,5 Gewichts-% beträgt.

**4.** Vorläufer einer lithografischen Druckplatte, der nach dem Verfahren gemäß irgendeinem der Ansprüche 1-3 erhalten werden kann.

**5.** Verfahren zur Herstellung einer lithografischen Druckplatte nach dem Silberkomplex-Diffusuionsübertragungsverfahren, das die folgenden Schritte umfaßt:
- informationsweise Belichtung eines Vorläufers einer lithografischen Druckplatte, wie beschrieben in Anspruch 4, und
- Entwicklung des informationsweise belichteten Vorläufers einer lithografischen Druckplatte in der Gegenwart einer oder mehrerer Entwicklersubstanzen und eines oder mehrerer Silberhalogenid-Lösungsmittel.

## Revendications

**1.** Une méthode pour la production d'un précurseur de plaque d'impression lithographique comprenant les étapes d'enduire une face d'un support d'une couche photosensible contenant une émulsion d'halogénure d'argent, d'une couche superficielle contenant des germes de développement physique et d'éventuelles couches hydrophiles en relation de perméabilité à l'eau avec ces couches photosensible et superficielle hydrophile, caractérisée en ce qu'au moins une de ces couches sur ce support est enduite à partir d'une solution d'enduction contenant un colloide hydrophile dans une concentration d'au moins 7 % en poids.

**2.** Une méthode selon la revendication 1, caractérisée en ce que ces couches appliquées à partir d'une solution d'enduction contenant un colloide hydrophile dans une concentration d'au moins 7 % en poids, sont appliquées à l'aide du procédé d'enduction sous forme de rideau.

**3.** Une méthode selon la revendication 1 ou 2, caractérisée en ce que la concentration du colloide hydrophile est d'au moins 7,5 % en poids.

**4.** Un précurseur de plaque d'impression lithographique pouvant être obtenu par la méthode décrite dans une quelconque des revendications 1 à 3.

**5.** Une méthode pour la production d'une plaque d'impression lithographique suivant le procédé d'inversion-transfert par diffusion de complexes d'argent comprenant les étapes suivantes:
- exposition sous forme d'information d'un précurseur de plaque d'impression lithographique comme défini dans la revendication 4, et
- développement de ce précurseur de plaque d'impression lithographique exposé sous forme d'information en présence d'un ou de plusieurs agents révélateurs et d'un ou de plusieurs solvants d'halogénure d'argent.